(19) Europäisches Patentamt
European Patent Office
Office européen des brevets

(11) Numéro de publication: **0 038 733**
**A2**

# (12) DEMANDE DE BREVET EUROPEEN

(21) Numéro de dépôt: 81400542.7

(22) Date de dépôt: 03.04.81

(51) Int. Cl.$^3$: **H 01 L 31/10**

(30) Priorité: 23.04.80 FR 8009114

(43) Date de publication de la demande:
28.10.81 Bulletin 81/43

(84) Etats contractants désignés:
DE FR GB IT NL SE

(71) Demandeur: THOMSON-CSF
173, Boulevard Haussmann
F-75360 Paris Cedex 08(FR)

(72) Inventeur: Pearsall, Thomas
THOMSON-CSF SCPI 173, bld Haussmann
F-75360 Paris Cedex 08(FR)

(74) Mandataire: Giraud, Pierre et al,
"THOMSON-CSF" - SCPI 173, bld Haussmann
F-75360 Paris Cedex 08(FR)

## (54) Photodiode de télécommunication à courant d'obscurité minimal.

(57) L'invention a pour but de minimiser le courant d'obscurité dans une photodiode destinée à absorber une radiation de longueur d'onde prédéterminée, et comportant, par conséquent, un matériau semiconducteur, d'absorption optique, à bande interdite relativement étroite.

La photodiode selon l'invention comporte une jonction métallurgique entre une couche (32) d'un premier matériau $Ga_x In_{1-x} As$, x étant par exemple égal à 0,47 en vue d'absorber préférentiellement la radiation infrarouge 1,55 $\mu$, et une deuxième couche (33) en InP, dont la bande interdite est beaucoup plus large que celle du premier matériau, une jonction semiconductrice distincte de la jonction métallurgique étant située entièrement dans InP entre une couche p+ (33) et une couche n (34).

Application aux télécommunications par fibres optiques.

EP 0 038 733 A2

./...

Croydon Printing Company Ltd.

FIG. 3

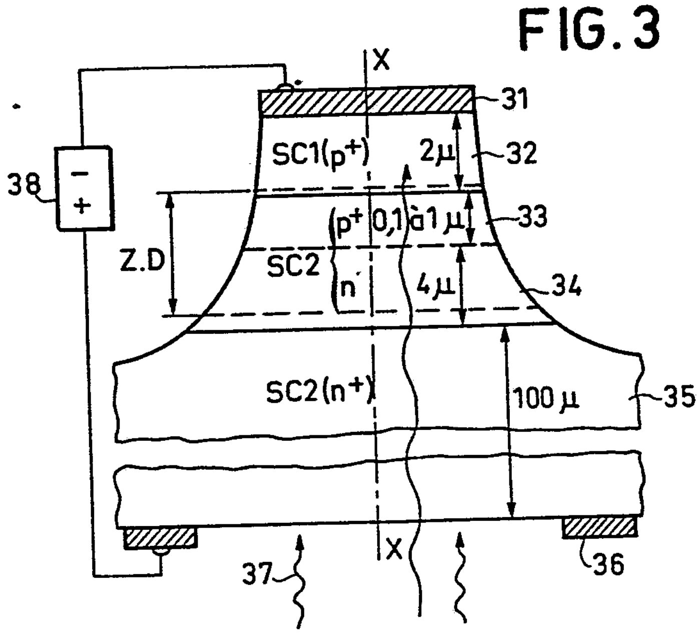

PHOTODIODE DE TELECOMMUNICATIONS A COURANT D'OBSCURITE MINIMAL

L'invention a pour but la diminution du courant d'obscurité, dans une photodiode destinée aux télécommunications sur fibres optiques, comportant un matériau semiconducteur à bande interdite relativement faible, choisie en fonction de la longueur d'onde de la lumière utilisée dans un système de télécommunications déterminé.

On sait, en effet, que le courant d'obscurité, dit aussi courant de fuite, est d'autant plus fort que la bande interdite est plus faible.

On a proposé d'éviter cet inconvénient en utilisant des photodiodes à hétérojonction, comportant un premier matériau semiconducteur, présentant un premier type de conductivité, à faible bande interdite et un deuxième matériau semiconducteur à bande interdite plus grande que celle du premier matériau, comprenant une première région du même type de conductivité que le premier matériau, et une deuxième région semiconductrice présentant un type opposé de conductivité, formant avec la première une jonction semiconductrice.

Toutefois, dans ce type de solutions, il existe encore des inconvénients, qui empêchent d'obtenir la réduction maximale de courant d'obscurité, parce qu'on n'a pas réuni les conditions pour que, dans la photodiode sous tension de fonctionnement :

a) la région de charge d'espace (ou zone déserte) soit minimale dans le premier matériau à faible bande interdite ;

b) ladite région soit principalement localisée dans le deuxième matériau dont le taux de génération de charge d'espace, donc le courant d'obscurité, est moindre que celui du premier matériau en raison de sa plus grande bande interdite ;

c) ladite région soit assez étendue en profondeur pour procurer à la photodiode une grande capacité de jonction particulièrement intéressante dans l'utilisation en télécommunications.

La photodiode selon l'invention est du type comportant une première couche faite d'un premier matériau semiconducteur

présentant un premier type de conductivité et dont la bande interdite est déterminée en fonction de la longueur d'onde de la lumière à absorber, et une deuxième et troisième couches faites d'un deuxième matériau semiconducteur à bande interdite plus grande que celle du premier matériau, la deuxième couche étant du même type de conductivité que la première et la troisième couche étant du type de conductivité opposé.

Elle est caractérisée en ce que la première et la deuxième couches sont fortement dopées, l'épaisseur de la deuxième couche est plus faible que celle de la première et la troisième couche est peu dopée tout en étant d'une épaisseur plus grande que celle de la deuxième couche.

L'invention sera mieux comprise, et d'autres caractéristiques apparaitront, au moyen de la description qui suit, et des dessins qui l'accompagnent parmi lesquels :

la figure 1 représente les bandes de valence et de conduction d'une structure classique de photodiode ;

la figure 2 représente les bandes de valence et de conduction d'une structure selon l'invention ;

les figures 3 et 4 sont des vues en coupe de photodiodes selon l'invention.

Les phénomènes de base utilisés dans le cadre de l'invention sont passés ci-après en revue, notamment en prenant comme exemple un matériau semiconducteur à faible bande interdite, apte à l'absorption de lumière de longueur d'onde 1,55 micron, et de formule :

$$Ga_{0,47}\ In_{0,53}\ As.$$

On a représenté figure 1 les bandes de valence et de conduction d'une structure comportant une couche dopée p et une couche dopée n de ce matériau semiconducteur. On distingue dans la structure, lorsqu'on progresse suivant un axe Ox perpendiculaire aux couches p et n, une première région 1, comportant la majeure partie de la couche p, dans laquelle les trous sont majoritaires, à l'autre extrémité, on trouve une région 3 comprenant la majeure partie de la couche n, dans laquelle les électrons sont majoritaires, entre les deux régions on distingue une région intermédiaire 2, qui

est la zone déserte dite de "charge d'espace", laquelle est vidée d'électrons et de trous. Des courbes $C_1$ et $C_2$ délimitent la bande interdite en l'absence de polarisation extérieure. On désigne ci-après par $J_1$ et $J_2$ les densités de courant d'obscurité correspondant respectivement au phénomène de génération et de recombinaison des paires électron-trou dans la région 2 et au phénomène de diffusion des électrons et des trous dans l'ensemble de la structure.

Le courant $J_1$ obéit à la loi de formation suivante :

$$J_1 \ (A/cm^2) = \frac{e \ n_i \ W}{2 \ \tau_o} \qquad (1)$$

formule dans laquelle :

e est la charge de l'électron ;

$n_i$ est la densité intrinsèque du nombre de porteurs de charge ;

W est l'épaisseur de la région 2 ;

$\tau_o$ est la constante de temps de recombinaison, obéissant à la loi suivante :

$$\tau_o = 10^{-9} \cosh E_g/kT \qquad (2)$$

avec :

$E_g$ : largeur de bande interdite en électron-volts ;

k : constante de Boltzmann ;

T : température absolue en degrés Kelvin.

De la combinaison des relations (1) et (2) on déduit que, pour diminuer $J_1$, il convient d'augmenter la largeur de la bande interdite soit le terme $E_g$. En effet, la croissance du terme $\tau_o$, et la diminution de $n_i$ sont quasi-exponentielles par rapport à $E_g$.

Le courant $J_2$ obéit à la loi ci-après :

$$J_2 \ (A/cm^2) = e \ n_i^2 \left( \frac{D_N}{N_1 \ L_n} + \frac{D_P}{N_3 \ L_P} \right) \qquad (3)$$

où $n_i$ et e désignent les mêmes grandeurs que plus haut, et en outre $D_N$ et $D_P$ sont les coefficients de diffusion des porteurs minoritaires créés par génération thermique dans les régions 1

et 3, on a :

$$D_N = \mu_e \frac{kT}{e} \qquad (4)$$

$$D_P = \mu_h \frac{kT}{e} \qquad (5)$$

avec :

$\mu_e$ et $\mu_h$ : mobilités des électrons et des trous, respectivement ;

$N_1$ et $N_3$ : nombres par $cm^3$ de porteurs majoritaires en régions 1 et 3 ;

$L_n$ et $L_p$ : libres parcours moyens des électrons et des trous dans les régions 1 et 3.

En conclusion, on voit facilement qu'en accroissant la largeur de bande interdite, on diminuerait fortement les courants $J_1$ et $J_2$ et leur somme, c'est à dire le courant d'obscurité, par suite de la diminution de $n_i$ dans les deux cas et de l'augmentation du terme $\tau_o$ dans le dénominateur de $J_1$ (voir formule 1). En outre, grâce au fait que la zone s'étend surtout dans le matériau de large bande interdite, on diminue encore le courant d'obscurité.

Sur la figure 2, on a représenté de façon analogue à celle de la figure 1, une structure conforme à l'invention.

Cette structure comporte deux matériaux semiconducteurs, l'un SC1 à faible largeur de bande interdite (par exemple 0,75 eV pour le matériau $Ga_{0,47}$ $In_{0,53}$ As) et l'autre SC2 à largeur de bande interdite nettement plus grande (par exemple 1,35 eV pour InP).

On distingue, dans la structure de la figure 2, les régions suivantes :

21 : région en matériau SC1, par exemple de type p+, d'épaisseur choisie pour absorber complètement le rayonnement (voir ci-après) ;

22, 23 et 24 : régions en matériau SC2, mais où l'on a :

22 : une région dopée p+ comme la région 21 ;

23 : une région dopée n (taux inférieur à $10^{16}$ $cm^{-3}$).

Si l'on compare les figures 1 et 2, on observe que :

1°) La jonction semiconductrice (région 23) est tout

entière située dans le matériau semiconducteur SC2 ;

2°) Les courbes $C_1$ et $C_2$, limites des bandes de valence et de conduction, sont moins écartées dans la région 21 que dans la région 22.

Pour obtenir une photodiode plus efficace, on complète la structure qui vient d'être décrite par un substrat n+ du côté de la région 23 et par des contacts ohmiques de part et d'autre de l'empilage afin de permettre l'application d'une polarisation extérieure.

Dans le cas général, l'épaisseur de la région 21 est choisie de façon à être d'un ordre de grandeur très voisin de la longueur efficace d'absorption optique à la longueur d'onde choisie par exemple 1,55 micromètre pour $Ga_{0,47}\ In_{0,53}\ As$.

Dans ce dernier cas, cette épaisseur sera comprise entre 1 et 2 micromètres.

L'épaisseur de la région 22 est aussi faible que possible (0,1 à 1 micron) obtenue par "autodopage" par contamination du deuxième matériau (InP) par le dopant du premier. La zone déserte occupe une petite partie de la région 21, la totalité de la région 22 et une grande partie de la région 23.

La région 21 en matériau SC1 pourrait présenter une conductivité de type n. Toutefois, on préfère une conductivité de type p, en raison de la plus grande longueur de diffusion des porteurs minoritaires (électrons dans le cas du dopage p).

Sur la figure 3, on a représenté, à titre d'exemple, une photodiode à structure mésa, dont la partie mésa est sensiblement cylindrique d'axe XX, comportant :

- un contact ohmique 31 recouvrant la partie mésa ;
- une couche 32 en matériau SC1 ($Ga_{0,47}\ In_{0,53}$) dopée p+ (taux égal ou supérieur à $10^{17}\ cm^{-3}$) ,d'épaisseur 2 microns ;
- une couche 33 en matériau SC2 (InP) dopée p+ ($10^{17} cm^{-3}$) ;
- une couche 34 en matériau SC2 dopée n (taux de $10^{15}\ cm^{-3}$), 4 à 5 microns ;
- un substrat 35 en matériau SC2 dopé n+.

La zone déserte (Z.D) occupe une très petite épaisseur dans la couche 32, la totalité de la couche 33 et une grande partie

de la couche 34.

Un contact ohmique de forme annulaire 36 laisse accéder la lumière (37) à la partie centrale de la face libre du substrat.

On a représenté en outre une source de polarisation extérieure 38, dont le pôle négatif est relié au contact 31.

Pour fabriquer cette photodiode, on part d'un substrat d'InP (35) dopé n+ sur lequel on dépose par exemple une couche épitaxiale d'InP, la couche 34 étant dopée n par diffusion du dopant du substrat, par exemple par chauffage, enfin l'on déposé par épitaxie une couche p+ de $Ga_{0,47}$ $In_{0,53}$ As (32) dopant la couche 33 par diffusion.

On effectue enfin une gravure mésa.

Sur la figure 4, on a représenté, à titre d'autre exemple de réalisation de l'invention, une photodiode de structure planar, comportant :

- un contact ohmique 41 de forme annulaire laissant accéder la lumière à la première couche ($Ga_{0,47}$ $In_{0,53}$ As) de la structure ;
- la première couche (42) en matériau SC1 dopé p+ ;
- une couche 43 en matériau SC2 (InP) dopé p+ ;
- une couche 44 en matériau SC2 dopé n ;
- un substrat 45 en matériau SC2 dopé n+ ;
- un contact ohmique 46.

On a représenté en outre une source de polarisation extérieure 48 dont le pôle négatif est relié au contact 41.

La fabrication d'une telle photodiode est effectuée de façon analogue à celle de la structure de la figure 3, sauf en ce qui concerne la gravure mésa.

D'autres variantes peuvent être réalisées de façon analogue aux photodiodes des figures 3 et 4 :

a) en remplaçant InP par $Ga_x$ $In_{1-x}$ $As_y$ $P_{1-y}$ (x et y étant des paramètres compris entre zéro et un) ce qui peut donner toutefois des courants d'obscurité moins bons que dans les exemples déjà cités ;

b) en remplaçant $Ga_{0,47}$ $In_{0,53}$ As par un composé quaternaire de la formule ci-dessus mais en choisissant x et y de façon

à absorber une lumière de longueur d'onde prédéterminée ;

c) en combinant les deux variantes (a) et (b) ci-dessus ;

d) en permutant les types de conductivité, les polarisations et éventuellement les faces d'accès de la lumière à absorber.

REVENDICATIONS

1. Photodiode de télécommunications à courant d'obscurité minimal du type comportant une première couche d'un premier matériau semiconducteur présentant un premier type de conductivité dont la bande interdite est déterminée en fonction de la longueur d'onde de la lumière à absorber, et une deuxième et troisième couches, un deuxième matériau semiconducteur à bande interdite plus grande que celle du premier matériau, la deuxième couche étant du même type de conductivité que la première, et la troisième couche étant du type de conductivité opposé, la photodiode étant caractérisée en ce que la première et la deuxième couche sont fortement dopées, l'épaisseur de la deuxième couche est plus faible que celle de la première, et la troisième couche est peu dopée et d'épaisseur plus grande que celle de la deuxième couche.

2. Photodiode suivant la revendication 1, caractérisée en ce que les matériaux semiconducteurs sont des composés distincts de même formule générale :

$$Ga_x\ In_{1-x}\ As_y\ P_{1-y}$$

avec :

$$0 \leq x \leq 1$$

$$0 \leq y \leq 1$$

x et y étant choisis de telle manière que la bande interdite du deuxième matériau soit plus large que celle du premier.

3. Photodiode suivant la revendication 2, caractérisée en ce que le premier matériau répond à la formule :

$$Ga_{0,47}\ In_{0,53}\ As$$

et le deuxième matériau est InP.

4. Photodiode selon l'une quelconque des revendications 1 à 3, caractérisée en ce qu'elle comporte un substrat fortement dopé du même type de conductivité que la troisième couche, ledit substrat supportant un empilage constitué successivement de la troisième, de la deuxième et de la première couche, des contacts ohmiques étant déposés respectivement sur la face du substrat opposée à l'empilage et sur la face libre de la première couche.

5. Photodiode selon la revendication 4, caractérisée en ce que l'empilage comporte une gravure mésa.

FIG.1

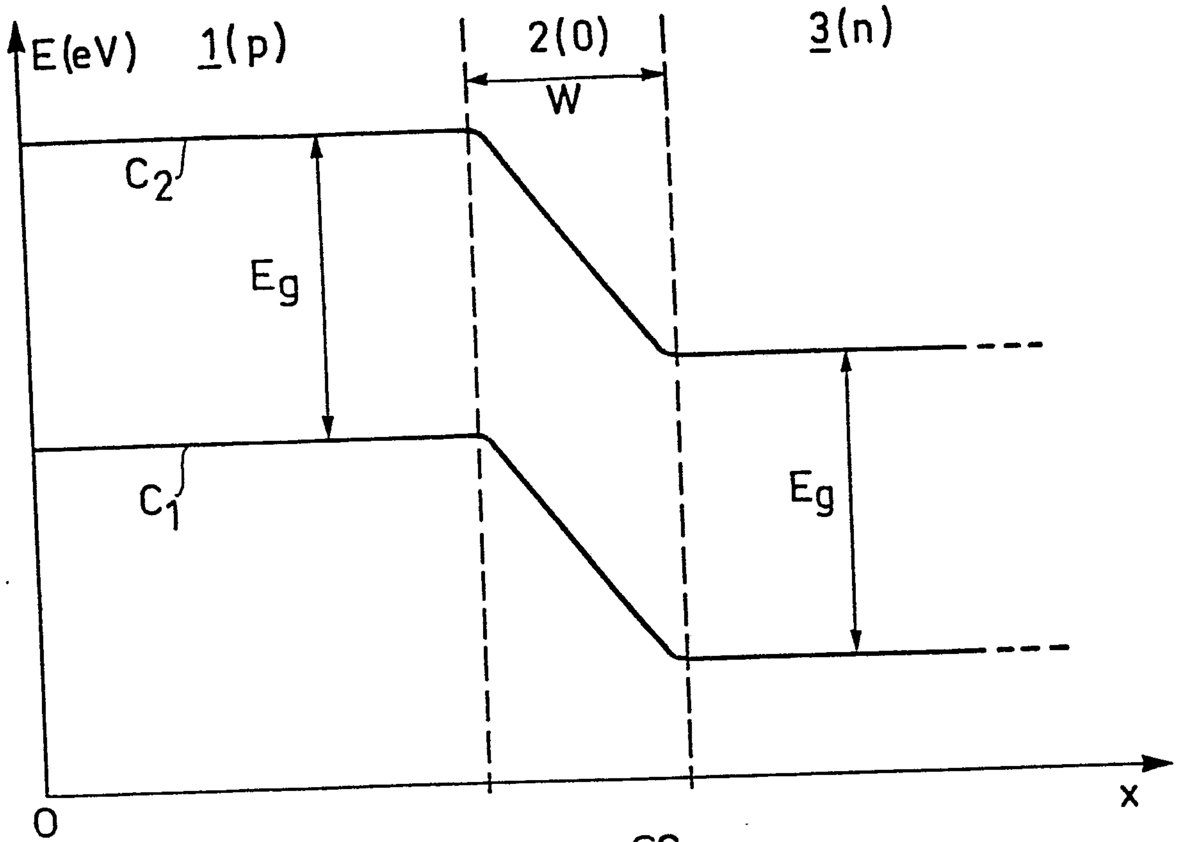
E(eV)
1(p)
2(0)
3(n)
W
C2
Eg
C1
Eg
O
x

FIG.2

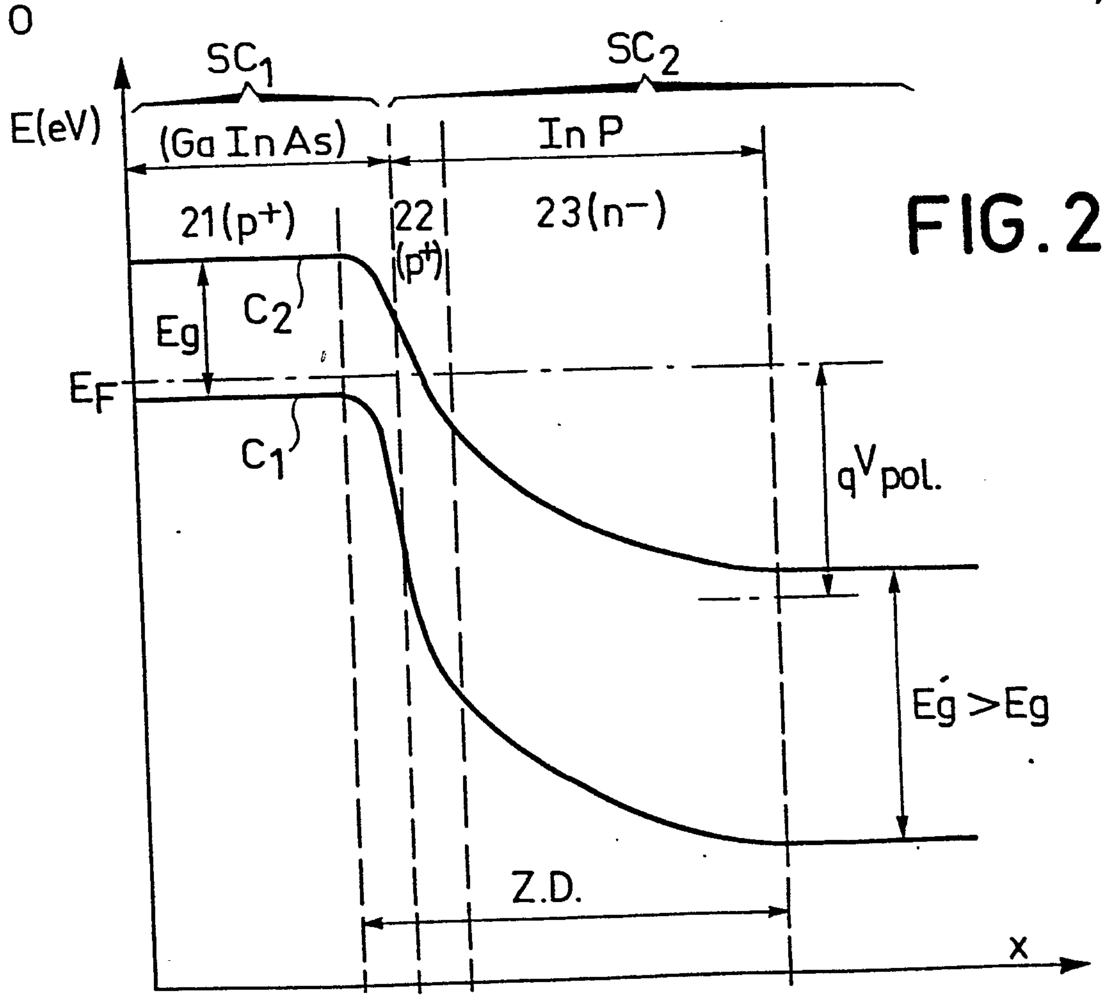
SC1
SC2
E(eV)
(Ga In As)
In P
21(p+)
22
(p+)
23(n−)
C2
Eg
EF
C1
qVpol.
Eg' > Eg
Z.D.
x

FIG.3

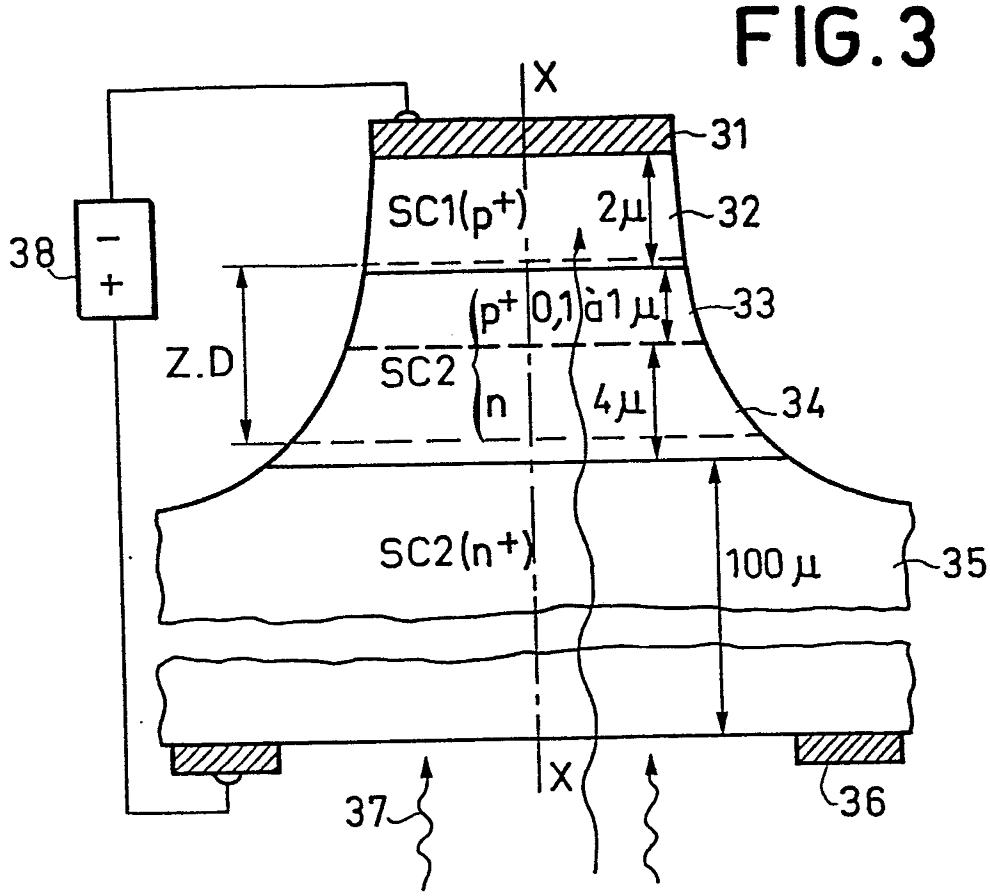
X
31
SC1(p+)
2μ
32
38
−
+
p+ 0,1 à 1 μ
33
Z.D
SC2
n
4μ
34
SC2(n+)
100 μ
35
X
37
36

FIG.4

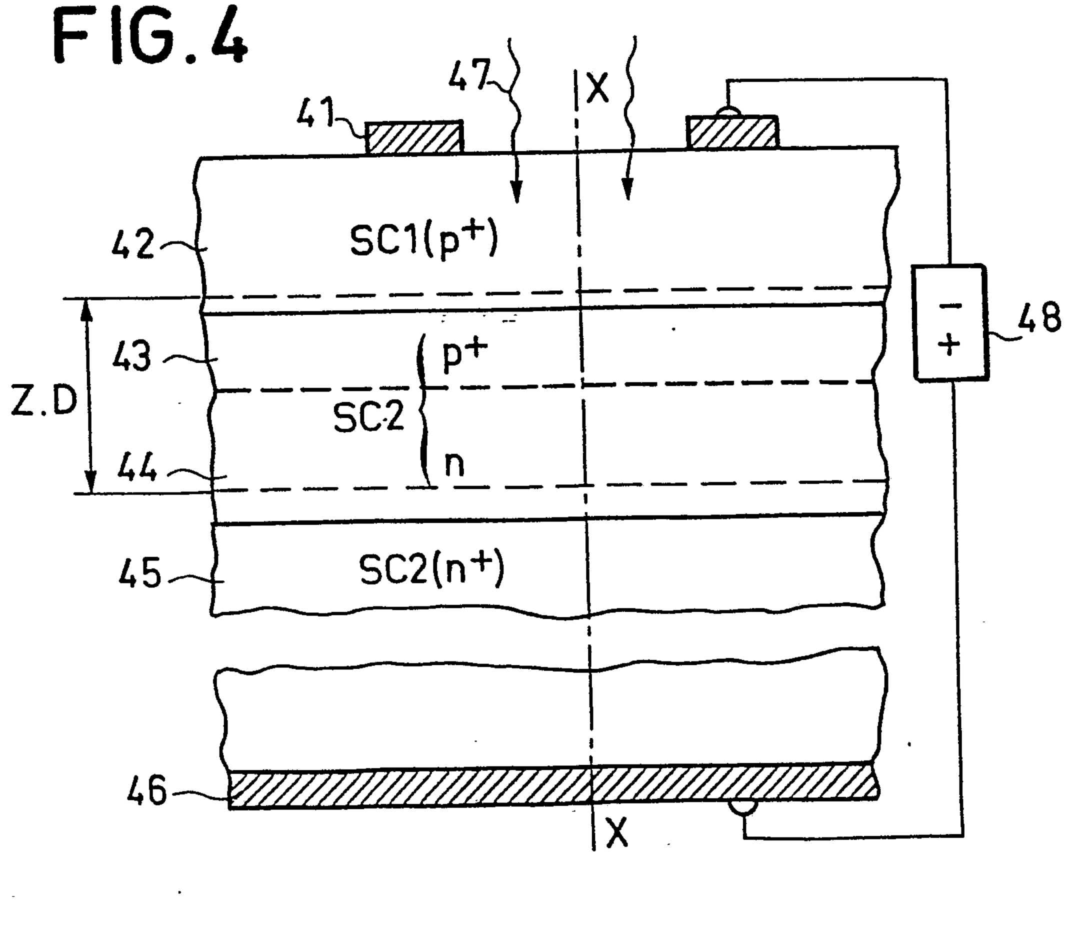
47
X
41
42
SC1(p+)
43
p+
48
−
+
Z.D
SC2
44
n
45
SC2(n+)
46
X